# EUROPEAN PATENT SPECIFICATION

(11) **EP 3 623 662 B1**
(45) Date of publication and mention of the grant of the patent: **29.12.2021**
(21) Application number: 19195453.6
(22) Date of filing: 04.09.2019
(51) Int. Cl.: F16H 61/00, F16H 61/30

(54) **ACTUATOR UNIT FOR A VEHICLE GEARBOX**
AKTUATOREINHEIT FÜR EIN FAHRZEUGGETRIEBE
UNITÉ D'ACTIONNEUR POUR UNE BOÎTE DE VITESSES DE VÉHICULE

(30) Priority: 12.09.2018 DE 102018122302
(43) Date of publication of application: 18.03.2020
(73) Proprietor: FTE automotive GmbH, 96106 Ebern (DE)
(72) Inventor: SCHORN, Andreas, D-96106 Ebern (DE); VOIGT, Christian, D-96106 Ebern (DE); ZÖTTLEIN, Mandy, D-96106 Ebern (DE); WAGNER, Sebastian, D-96106 Ebern (DE)
(74) Representative: Valeo Powertrain Systems

(56) References cited:
- EP-A1- 3 109 951
- DE-A1-102014 011 177
- US-A1- 2004 187 942
- US-B2- 6 441 609

## Description

The invention relates to an actuator unit for a vehicle gearbox.

The actuator unit contains a plurality of actuators with which a component to be actuated (for example a gear selector rod provided with gear selector fork) can in each case be adjusted. Gear changing of the vehicle gearbox can thereby be undertaken in the desired manner (in the above example, a gear can be engaged or disengaged).

The actuators can be small hydraulic cylinders with which a hydraulic pressure can be converted into a lifting movement. A piston is arranged here in the actuator and can be adjusted within a cylinder housing of the actuator.

For the activation of the actuator, it is expedient to have information about the position of the piston. For this purpose, it is known to arrange a sensor on the actuator, the sensor generating a position signal which depends on the position of the piston.

The sensor can be a Hall sensor, and a magnet can be mounted on the piston.

Such a construction is known from DE 10 2014 011 177 A1. The actuator unit shown there has four actuators which are each assigned a sensor. The sensors are arranged on a continuous flexible printed circuit board (FPCB) which is guided along the actuator unit from actuator to actuator, and therefore each sensor can be positioned in a receptacle provided therefor on the corresponding actuator.

A flexible printed circuit board fitted with the sensors has the advantage that it can be guided in a flexible manner, for example along the contour of the individual actuators. The disadvantage of such a printed circuit board consists in that its installation is rather complicated.

It is the object of the invention to provide an actuator unit which can be fitted with sensors with little effort, in particular in an automated manner.

To achieve this object, according to the invention an actuator unit is provided which has a baseplate, a plurality of actuators which are mounted on the baseplate, a plurality of sensors which are assigned at least to some of the actuators, and a flexible printed circuit board on which the sensors are mounted, wherein the flexible printed circuit board is provided with a plurality of latching elements with which it is fixed on the baseplate. The invention is based on the basic concept of providing the flexible printed circuit board with dedicated fastening elements, the latching elements, which can be fastened in an automated manner, as a result of which the flexible printed circuit board, and therefore the sensors mounted thereon, are then also preassembled. The printed circuit board together with the sensors is not mounted here on the actuators, as is known from DE 10 2014 011 177A1 mentioned above, but rather on a baseplate on which the actuators are then also mounted. The baseplate serves here as a type of installation support on which the sensors are mounted first, followed by the actuators.

According to an embodiment of the invention, it is provided that the latching elements are of plate-like design and each have a plurality of latching pins. By this means, the latching element has comparatively large dimensions, and therefore it can easily be grafted and mounted by an installation robot.

Each latching element here preferably has an area which is at least twice the area of the associated sensor. However, the latching element may also be significantly larger than the sensor, for example may have ten times the area. It is likewise preferred for the latching element to protrude laterally over the flexible printed circuit board or to at least end flush therewith so that it can be grafted by an installation robot without there being the risk of the flexible printed circuit board being damaged.

The latching pins can have elastically deformable lugs which can be pressed into suitable bores or openings in the baseplate and remain there by frictional locking.

A latching element is preferably in each case arranged below a sensor, and therefore the latching element forms a stable base for the sensor which is thereby mounted in a precise position.

The latching elements can be laminated or adhesively bonded onto the flexible printed circuit board such that they form a preassembled unit with the flexible printed circuit board.

A seal is preferably arranged between the actuator and the flexible printed circuit board, and therefore the sensor is readily protected from soiling, in particular from abrasion.

The seal here is advantageously pretensioned, thus resulting in a high sealing effect.

According to a preferred refinement, the seal surrounds the sensor annularly, and it is arranged in an annular groove which is provided on that side of the actuator which faces the sensor. By this means, the seal can be preassembled in the groove, and therefore it automatically provides a seal in the desired manner around the sensor when the actuator is installed.

The invention is described below with reference to an embodiment and is illustrated in the attached drawings. In the drawings:
Figure 1 shows a perspective view of an actuator unit according to the invention;
Figure 2 shows the actuator unit from Figure 1, wherein some of the actuators have been removed so that the flexible printed circuit board can be seen better;
Figure 3 shows a schematic section of an actuator with an associated sensor;
Figure 4 shows a perspective view of the installation of the flexible printed circuit board on the baseplate;
Figure 5 shows a perspective view of an actuator with an associated seal and sensor;
Figure 6 shows a perspective bottom view of the actuator from Figure 5 with an associated seal;
Figure 7 shows a schematic sectional view of the actuator with a preassembled seal before the installation on the baseplate;
Figure 8 shows a schematic sectional view of the actuator mounted on the baseplate;

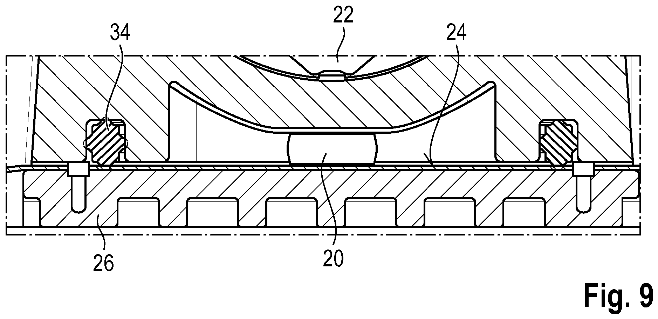

Figure 9 shows the actuator from Figure 8 in another sectional plane;
Figure 10 shows a perspective view of a plug preassembled on the baseplate before the fastening clip is attached;
Figure 11 shows the plug from Figure 10 in a top view;
Figure 12 shows a view corresponding to that of Figure 10 with the fastening clip attached;
Figure 13 shows a section level with the groove through the plug with the fastening clip attached to the plug;
Figure 14 shows, in a view similar to Figure 1, part of a baseplate with actuators, flexible printed circuit board and a temperature sensor mounted thereon;
Figure 15 shows the part facing away from the plug of a variant embodiment of a flexible printed circuit board on which a temperature sensor is mounted; and

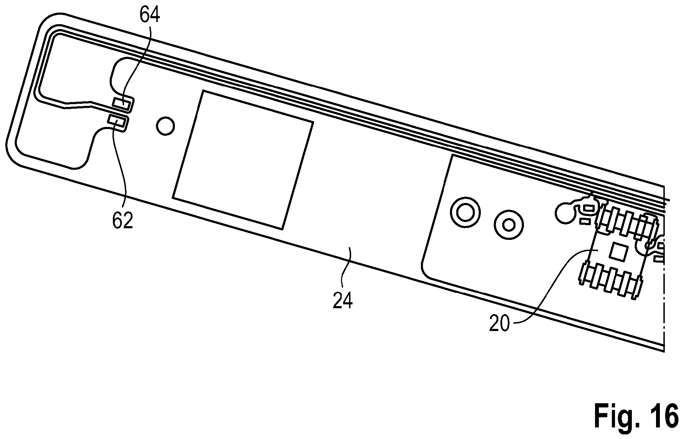

Figure 16 shows, on an enlarged scale, the section of a flexible printed circuit board that is provided for supporting the temperature sensor.

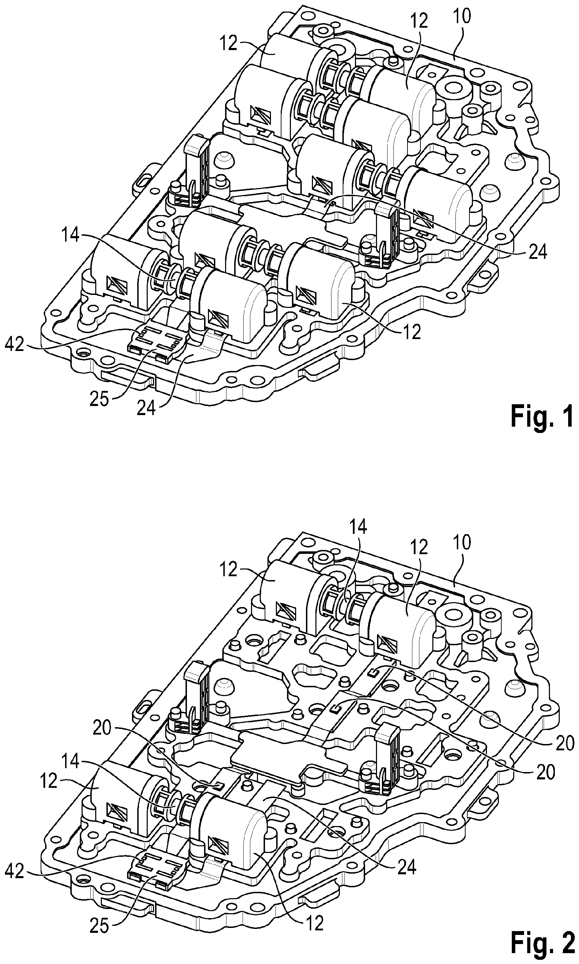

Figures 1 and 2 show an example of an actuator unit which is provided for adjusting a component to be actuated of a manual gearbox. This can be, for example, a gear selector fork.

The actuator unit has a baseplate 10 on which a plurality of actuators 12 are arranged. The latter are arranged here opposite one another in pairs and act on a common actuator rod 14.

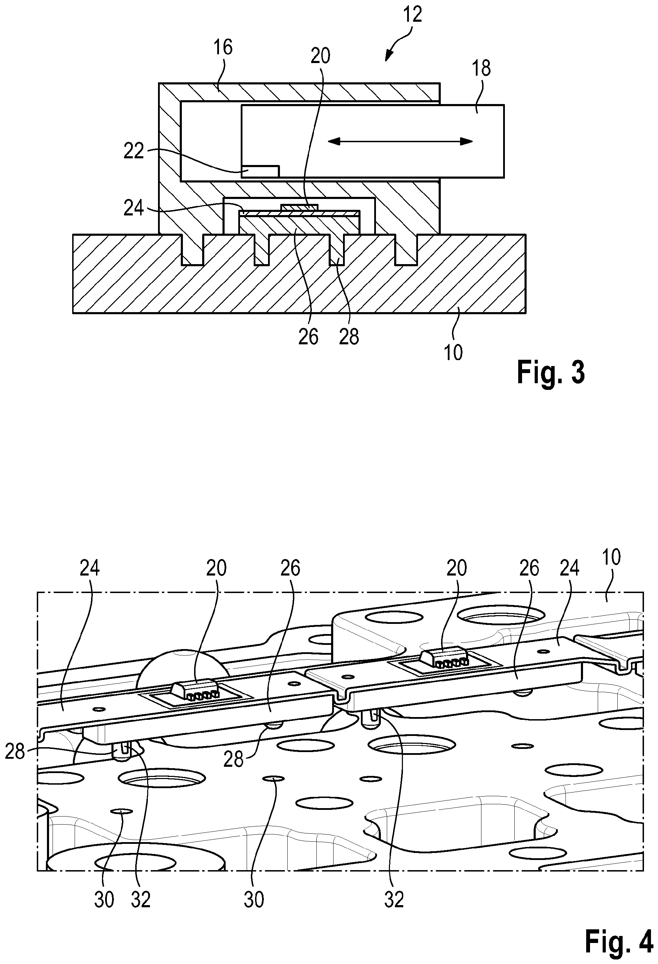

Each actuator is a hydraulic cylinder with a cylinder housing 16 (also see Figure 3) in which a piston 18 is arranged. The piston is connected to the actuator rod 14.

The actuator rod 14 can be actuated in the desired manner by application of a hydraulic pressure on one side of the piston 18.

So that information about the position of the piston 18 and therefore of the actuator rod 14 is available to an electronic control system (not shown here), a sensor 20 is provided which is arranged directly adjacent to the cylinder housing 16. The sensor 20 can be a Hall sensor which responds to the magnetic field of a magnet 22 mounted on the piston 18.

Since, in the exemplary embodiment shown, two actuators are always connected to each other via a common actuator rod 14, it is sufficient to provide a sensor 20 on one of the two actuators 12 of a pair. A plurality of sensors are therefore provided which are assigned at least to some of the actuators (specifically to every two).

The sensors 20 are all arranged on a flexible printed circuit board 24 which extends along the baseplate 10.

In the exemplary embodiment shown, the flexible printed circuit board 24 extends with a main arm over virtually the entire baseplate 10, and therefore it bears four sensors for four pairs of actuators 12, and a shorter secondary arm is provided which bears a sensor 20 for the fifth actuator pair.

For the electrical connection of the flexible printed circuit board 24 and therefore of the sensors 20, a plug 25 is provided which is arranged here in the vicinity of a side edge of the baseplate 10. The two arms of the flexible printed circuit board 24 emerge from the plug 25.

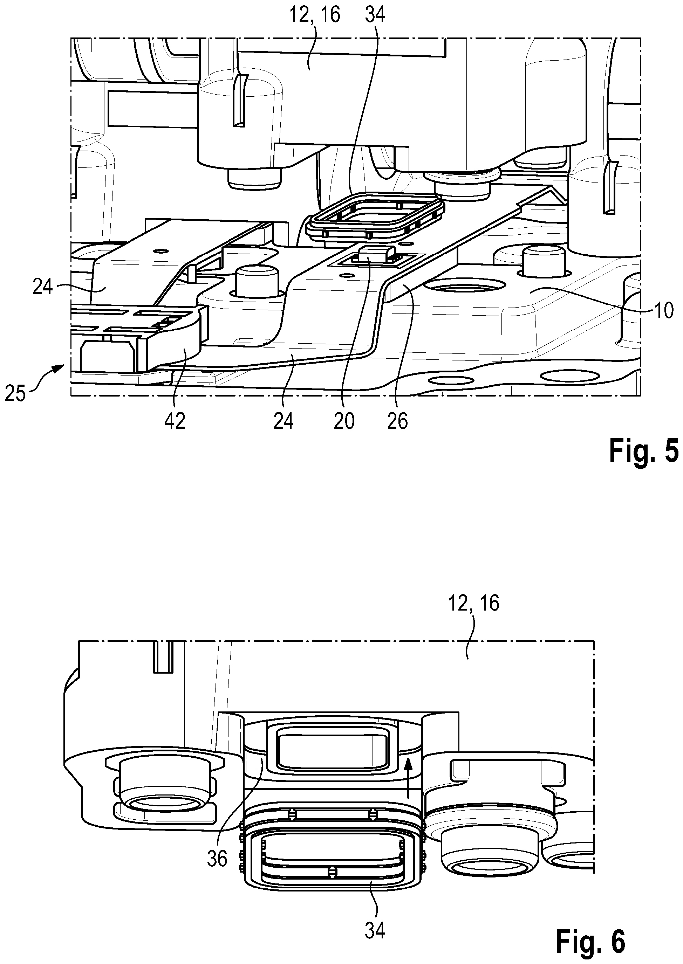

Each sensor 20 is assigned a latching element 26 which here is in the form of a rectangular plate (also see Figures 4 and 5).

Each latching element 26 is arranged here below the corresponding sensor 20. It is adhesively bonded or laminated onto the flexible printed circuit board 24.

On the side facing away from the flexible printed circuit board 24, each latching element 26 is provided with a plurality of latching pins 28 which are provided for engaging in associated openings 30 in the baseplate 10.

In order to improve the frictional locking of the latching pins 28 in the openings 30, each latching pin 28 has at least one and preferably more than one elastically deformable lug 32.

As can be seen in Figures 5 and 6, an annular seal 34 is provided for each sensor 20, said seal providing a seal around a sensor 20 between the cylinder housing 16 of the actuator 12 and the flexible printed circuit board 24. The seal 34 is composed of a suitable elastically deformable material and is accommodated in a groove 36 which is formed on that side of the cylinder housing 16 of the actuator 12 which faces the printed circuit board 24.

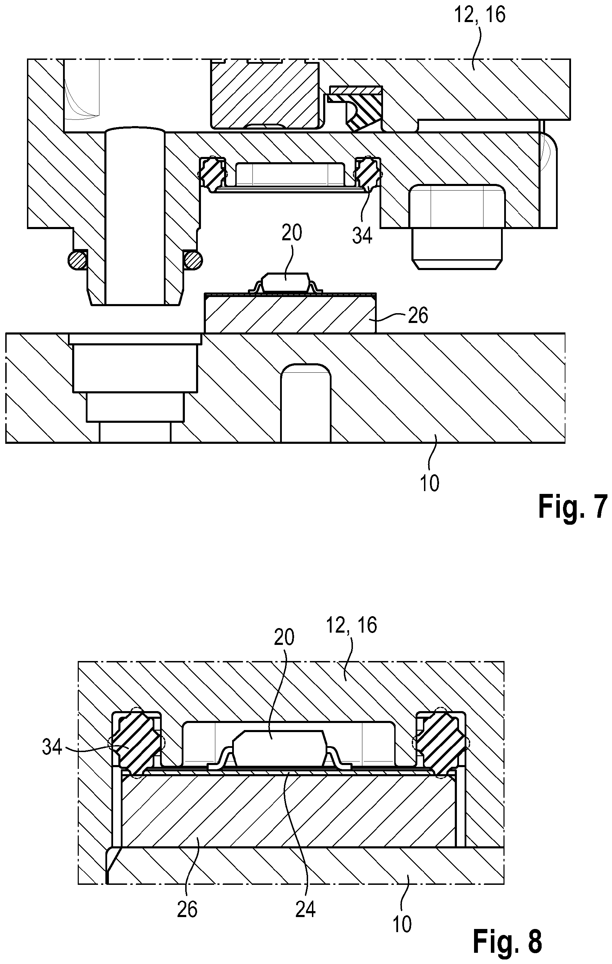

Figure 7 shows an intermediate step during the installation of the actuator unit. The plate-like latching element 26 is already preassembled together with the sensor 20 on the baseplate. Accordingly, the entire flexible printed circuit board 24 is fixed on the baseplate 10. Subsequently, the actuator 12 on which the seal 34 is already preassembled is mounted on the baseplate 10.

The actuator 12 mounted above the sensor 20 can be seen in Figure 8. The latching element 26 ensures here that the sensor 20 is in a precise position, predetermined with low tolerances, relative to the actuator 12. At the same time, the seal 34 provides a reliable seal between the cylinder housing 16 of the actuator 12 and the flexible printed circuit board 24 since it is held with pretension in the installation direction.

The actuator 12 reliably holds the sensor in its position with the pretension of the seal 34 and also prevents the sensor being detached from the baseplate.

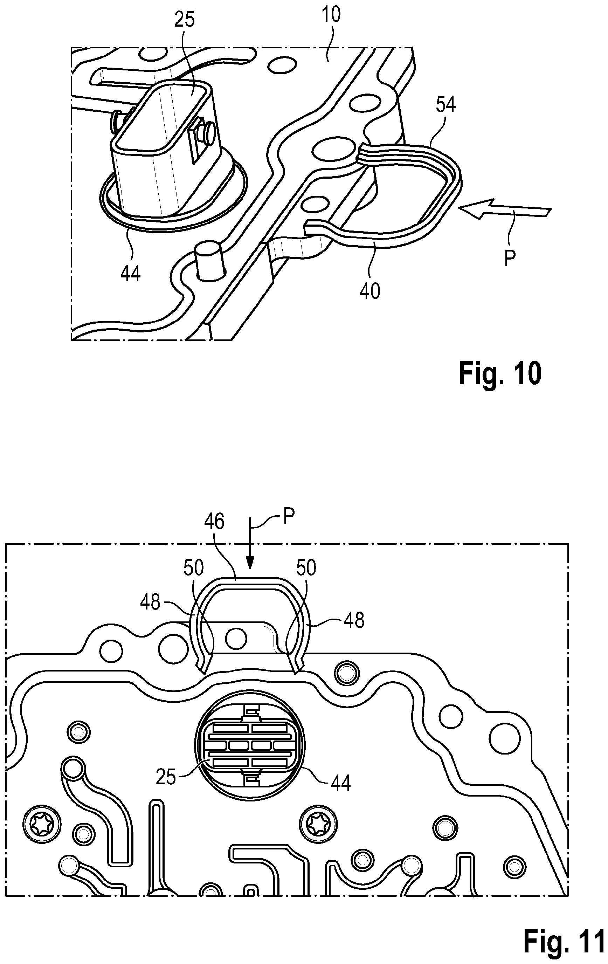

The plug 25 (also see Figures 10 to 12) is fastened to the baseplate 10 by said plug being provided on one side (the side of the flexible printed circuit board 24) with a contact surface and being locked on the opposite side by means of a fastening clip 40.

The contact surface is that side of the contact plate 42, which is visible in Figures 1, 2 and 5, which faces the baseplate 10.

On the opposite side, the plug 25 is provided with a groove 44 into which the fastening clip 40 can be latched. The fastening clip 40 has a generally C-shaped configuration with a central web 46 and two side webs 48.

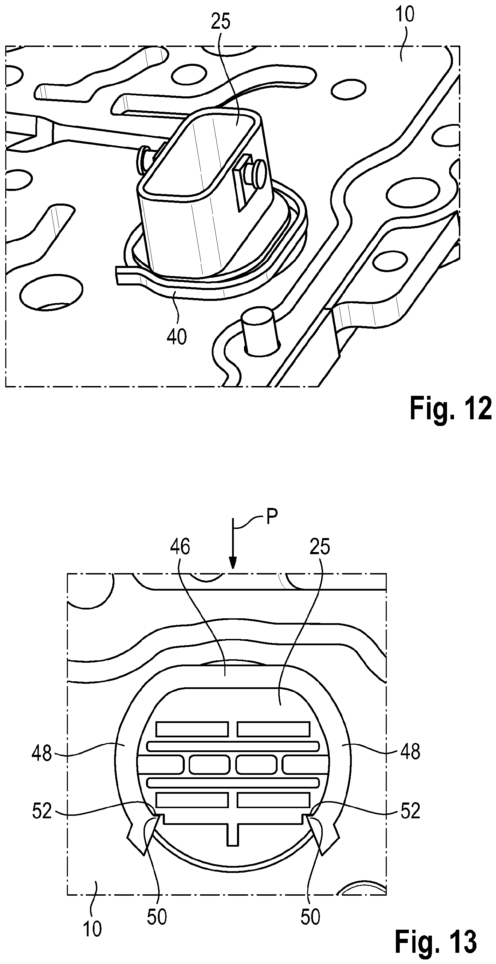

At the free end of each side web 48, a latching lug 50 is provided which, when the fastening clip is fitted, lies against a latching surface 52 which is provided within the groove 44 (see in particular Figure 13). The latching surfaces 53 and those surfaces of the latching lugs 50 which interact therewith are oriented perpendicularly to the direction P in which the fastening clip 40 is pushed into the groove 44 of the plug 25.

The elasticity of the fastening clip 40 is selected in such a manner that it can be pushed into the groove 44 of the plug 25 in the radial direction with respect to the plug without a special tool for widening the two side limbs 48 being required for this purpose. The fastening clip 40 can therefore be mounted by simple pushing in the radial direction. It then comes to lie in the groove 44 in such a manner that it is supported on the baseplate 10, and therefore the plug 25 cannot be removed from the opening in the baseplate into which it has been inserted.

In order to obtain particularly high shearing forces, the fastening clip 40 has an encircling raised edge 54 which comes to lie outside the groove 44 when the fastening clip 40 is mounted.

The baseplate 10 is also provided with a temperature sensor 60 in order to obtain a signal about the oil temperature. The temperature sensor is mounted here directly on the flexible printed circuit board 24, and therefore no separate component has to be mounted on the baseplate 10 and also no separate component has to be electrically contacted.

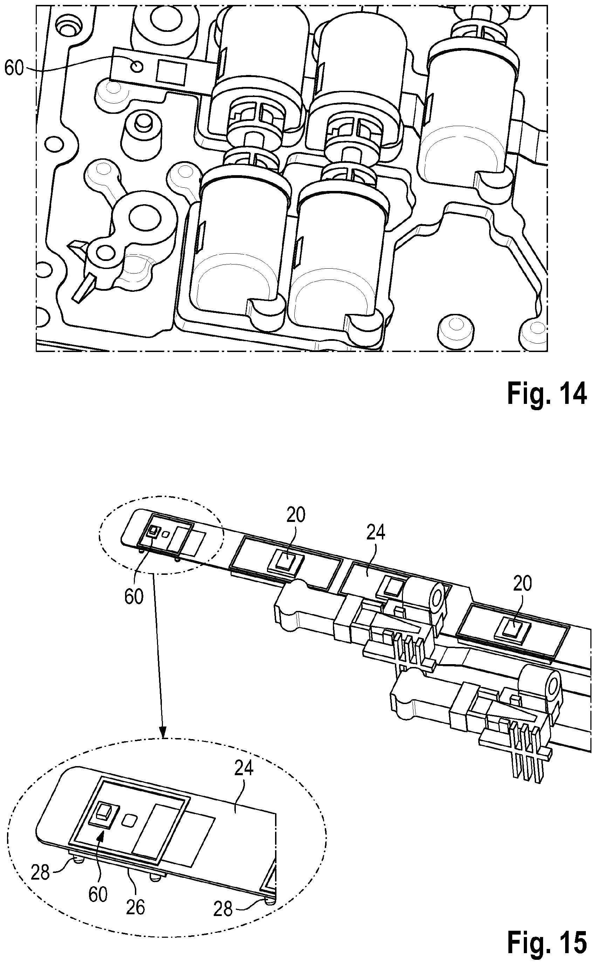

In the embodiment shown in Figure 14, the temperature sensor 60 is arranged at the free end of the flexible printed circuit board 24, i.e. at the end facing away from the plug 25.

However, the temperature sensor 60 may also be arranged at other locations of the flexible printed circuit board 24 depending on the structural circumstances. In principle, any location is suitable on which there is sufficient space on the printed circuit board 24 and which is exposed during operation to the gearbox oil, the temperature of which is intended to be measured.

Below the temperature sensor 60, a latching element 26 having latching pins 28 is mounted on the flexible printed circuit board 24 in the same manner as in the case of the sensors 20. The latching element makes it possible to reliably fasten the flexible printed circuit board 24 in the region of the temperature sensor 60, and therefore the temperature sensor 60, to the baseplate 10.

It can be seen in Figure 15 that the temperature sensor 60 is arranged in the vicinity of other components on the flexible printed circuit board, in particular in the vicinity of the sensors 20 with which the position of the actuators is sensed.

The temperature sensor 60 is in particular an NTC resistor which is mounted on two contact surfaces 62, 64 which are connected to the plug 25 via strip conductors 66, 68 of the flexible printed circuit board 24.

## Claims

1. Actuator unit for a vehicle gearbox, with a baseplate (10), a plurality of actuators (12) which are mounted on the baseplate (10), a plurality of sensors (20) which are assigned at least to some of the actuators (12), and a flexible printed circuit board (24) on which the sensors (20) are mounted, wherein the flexible printed circuit board (24) is provided with a plurality of latching elements (26) with which it is fixed on the baseplate (10).

2. Actuator unit according to Claim 1, **characterized in that** the latching elements (26) are of plate-like design and each have a plurality of latching pins (28).

3. Actuator unit according to Claim 2, **characterized in that** the latching pins (28) have elastically deformable lugs (32).

4. Actuator unit according to one of the preceding claims, **characterized in that** each latching element (26) has an area which is at least twice the area of the associated sensor (20).

5. Actuator unit according to one of the preceding claims, **characterized in that** a latching element (26) is in each case arranged below a sensor (20).

6. Actuator unit according to one of the preceding claims, **characterized in that** the latching elements (26) are laminated or adhesively bonded onto the flexible printed circuit board (24).

7. Actuator unit according to one of the preceding claims, **characterized in that** a seal (34) is arranged between the actuator (12) and the flexible printed circuit board (24).

8. Actuator unit according to Claim 7, **characterized in that** the seal (34) is pretensioned.

9. Actuator unit according to Claim 7 or Claim 8, **characterized in that** the seal (34) annularly surrounds the sensor (20).

10. Actuator unit according to one of Claims 7 to 9, **characterized in that** the seal (34) is arranged in an annular groove (36) which is provided on that side of the actuator (12) which faces the sensor (20).

## Patentansprüche

1. Aktoreinheit für ein Fahrzeuggetriebe, mit einer Grundplatte (10), mehreren Aktoren (12), die auf der Grundplatte (10) angebracht sind, mehreren Sensoren (20), die zumindest einigen der Aktoren (12) zugeordnet sind, und einer flexiblen Leiterplatte (24), auf der die Sensoren (20) angebracht sind, wobei die flexible Leiterplatte (24) mit mehreren Rastelementen (26) versehen ist, mit denen sie an der Grundplatte (10) fixiert ist.

2. Aktoreinheit nach Anspruch 1, **dadurch gekennzeichnet, dass** die Rastelemente (26) plattenförmig ausgebildet sind und jeweils mehrere Raststifte (28) aufweisen.

3. Aktoreinheit nach Anspruch 2, **dadurch gekennzeichnet, dass** die Raststifte (28) elastisch verformbare Nasen (32) aufweisen.

4. Aktoreinheit nach einem der vorhergehenden Ansprüche, **dadurch gekennzeichnet, dass** jedes Rastelement (26) eine Grundfläche aufweist, die mindestens das Doppelte der Grundfläche des zugeordneten Sensors (20) beträgt.

5. Aktoreinheit nach einem der vorhergehenden Ansprüche, **dadurch gekennzeichnet, dass** jeweils ein Rastelement (26) unterhalb eines Sensors (20) angeordnet ist.

6. Aktoreinheit nach einem der vorhergehenden Ansprüche, **dadurch gekennzeichnet, dass** die Rastelemente (26) auf die flexible Leiterplatte (24) auflaminiert oder aufgeklebt sind.

7. Aktoreinheit nach einem der vorhergehenden Ansprüche, **dadurch gekennzeichnet, dass** zwischen dem Aktor (12) und der flexiblen Leiterplatte (24) eine Dichtung (34) angeordnet ist.

8. Aktoreinheit nach Anspruch 7, **dadurch gekennzeichnet, dass** die Dichtung (34) vorgespannt ist.

9. Aktoreinheit nach Anspruch 7 oder Anspruch 8, **dadurch gekennzeichnet, dass** die Dichtung (34) den Sensor (20) ringförmig umgibt.

10. Aktoreinheit nach einem der Ansprüche 7 bis 9, **dadurch gekennzeichnet, dass** die Dichtung (34) in einer ringförmigen Nut (36) angeordnet ist, die auf der dem Sensor (20) zugewandten Seite des Aktors (12) vorgesehen ist.

## Revendications

1. Unité d'actionnement pour une boîte de vitesses de véhicule, avec une plaque de base (10), une pluralité d'actionneurs (12) qui sont montés sur la plaque de base (10), une pluralité de capteurs (20) qui sont affectés à au moins certains des actionneurs (12), et une carte de circuit imprimé flexible (24) sur laquelle sont montés les capteurs (20), la carte de circuit imprimé flexible (24) étant pourvue d'une pluralité d'éléments de verrouillage (26) avec lesquels elle est fixée sur la plaque de base (10).

2. Unité d'actionnement selon la revendication 1, **caractérisée en ce que** les éléments de verrouillage (26) sont d'une conception en forme de plaque et ont chacun une pluralité de goupilles de verrouillage (28).

3. Unité d'actionnement selon la revendication 2, **caractérisée en ce que** les goupilles de verrouillage (28) ont des saillies déformables élastiquement (32).

4. Unité d'actionnement selon une des revendications précédentes, **caractérisée en ce que** chaque élément de verrouillage (26) a une superficie qui représente au moins deux fois la superficie du capteur associé (20).

5. Unité d'actionnement selon une des revendications précédentes, **caractérisée en ce qu'**un élément de verrouillage (26) est dans chaque cas disposé sous un capteur (20).

6. Unité d'actionnement selon une des revendications précédentes, **caractérisée en ce que** les éléments de verrouillage (26) sont laminés ou collés par adhésif sur la carte de circuit imprimé flexible (24).

7. Unité d'actionnement selon une des revendications précédentes, **caractérisée en ce qu'**un joint d'étanchéité (34) est disposé entre l'actionneur (12) et la carte de circuit imprimé flexible (24).

8. Unité d'actionnement selon la revendication 7, **caractérisée en ce que** le joint d'étanchéité (34) est précontraint.

9. Unité d'actionnement selon la revendication 7 ou la revendication 8, **caractérisée en ce que** le joint d'étanchéité (34) entoure annulairement le capteur (20).

10. Unité d'actionnement selon une des revendications 7 à 9, **caractérisée en ce que** le joint d'étanchéité (34) est disposé dans une rainure annulaire (36) qui est ménagée sur le côté de l'actionneur (12) qui fait face au capteur (20).
